# EUROPEAN PATENT APPLICATION

(11) **EP 4 528 810 A1**
(43) Date of publication of application: **26.03.2025**
(21) Application number: 23199181.1
(22) Date of filing: 22.09.2023
(51) Int. Cl.: H01L 23/495, H01L 23/48

(54) **CLIP**

(71) Applicant: Nexperia B.V., 6534 AB Nijmegen (NL)
(72) Inventor: El-Zammar, Georgio, Hamburg (DE); Shiu, Heiming, 22529 Hamburg (DE)
(74) Representative: Pjanovic, Ilija

(57) **Abstract**

There is disclosed a clip for a semi-conductor device. The clip is provided with a plurality of holes. The plurality of holes define a hole density of at least 4 holes/mm².

## Description

### Field of Invention

The present invention relates to a clip for a semi-conductor device, and to a semiconductor device that comprises the clip.

### Background

Semiconductor assemblies, such as transistors, are manufactured as layered assemblies including components such as die paddles, dies, clips and a casing. The casing provides a protective functionality and at least partially surrounds the die and other components that form a part of the semiconductor assembly.

Semiconductor assemblies are subject to temperature fluctuations in use. These temperature fluctuations result in the expansion and contraction of the components of the clip. The coefficient of thermal expansion of each component varies, and so the amount by which each component expands and contracts as a result of temperature changes also varies. This leads to internal stresses accumulating within the components of the clip. The internal stresses are undesirable because they can result in delamination of the components of the clip. Other causes of delamination of the components of the clip exist.

There exists a need to overcome the disadvantages associated with existing semiconductor assemblies, and clips for semi-conductor assemblies, whether mentioned in this document or otherwise.

### Summary

In a first aspect of the invention there is provided a clip for a semi-conductor device. The clip is provided with a plurality of holes. The plurality of holes define a hole density of at least 4 holes/mm².

The hole density may be at least 25 holes/mm². The hole density may be up to 50 holes/mm² or 100 holes/mm². The hole density may be chosen based on, for example, the intended application of the semi-conductor device.

Hole density may be understood to refer to the number of holes present in the clip per unit area.

The clip may otherwise be referred to as a connector. The purpose of the clip is to electrically couple components of the semi-conductor device, and to act as a thermal path to dissipate device heat.

The holes may be through holes.

When assembled into the semi-conductor device, the clip is secured to a die of the semi-conductor device using, for example, solder. Since the clip is provided with a plurality of holes that define a hole density of at least 4 holes/mm², adhesion between the clip and the die is improved. This is because the solder enters the holes of the clip, therefore providing a greater contact area between the solder and the clip, and a greater solder volume. Furthermore, the thickness of the solder, referred to as the bond line thickness, to be increased as compared to a clip that does not include a plurality of holes. This further improves the strength of adhesion between the clip and the die. In addition, any excess solder enters the holes, allowing the holes to act as a reservoir for the solder. This allows better control of the thickness of the solder layer, which reduces the likelihood of separation of the components of the semi-conductor device. Furthermore, the solder reservoir assists in absorbing stress that the device is subjected to in use. This reduces the stress that any filler solder (being solder that extends around the external side walls of the clip) is subjected to in use, thereby reducing the likelihood of the filler solder cracking.

The semi-conductor device comprises an isolator that covers, and adheres to, the clip. The plurality of holes also improve adhesion between the clip and the isolator because the isolator enters the holes, providing a greater contact area between the isolator and the clip.

In use, semi-conductor devices are subject to temperature fluctuations, and may in some applications experience temperatures over a 200°C or greater range. For example, a semi-conductor may experience temperatures as low as -65°C (or lower), and up to 150°C (or higher). These fluctuations lead to variations in the sizes of the components of the devices due to thermal expansion. The clip is generally made from a different material to the die to which it is secured, and to the solder used to secure the clip to the die. For example, the clip may be made from copper whereas the die may be made from silicone and the solder from a lead alloy. Each of these materials has a different coefficient of thermal expansion, and so each of the components expands and contracts with temperature changes at a different rate. This leads to internal stresses building up within the components. The plurality of holes being provided at a hole density of at least 4 holes/mm² optimises the flexibility of the clip, which allows the clip to absorb the internal stresses that it is subject to, reducing the likelihood of delamination of the components occurring. Furthermore, since the bond line thickness of the solder is increased, as discussed above, more solder is provided, which reduces the internal stresses that the solder is subject to. This also reduces the likelihood of delamination of the components occurring.

A length of each hole of the plurality of holes may be at least 50µm. A length of each hole of the plurality of holes may be up to 500µm.

The length of each of the holes may be understood to refer to the largest dimension of the respective hole in a direction perpendicular to a central axis of the respective hole.

Within the specified range, the adhesion between the clip and the die, and between the clip and the isolator, can be optimised for a given application.

The holes may be circular, triangular, and/or rectangular in cross-section.

The plurality of holes may all be circular in cross-section. The plurality of holes may all be triangular in cross-section. The plurality of holes may all be rectangular in cross-section. At least some holes of the plurality of holes may be circular in cross-section, at least some holes of the plurality of holes may be triangular in cross-section, and at least some holes of the plurality of holes may be rectangular in cross-section. The cross-sectional shape of the plurality of holes may be as viewed from a top of the device. The plane of the cross-section may extend normal to a central axis of the relevant hole.

The shape of the holes may be chosen based on the application of the device, and each may be particularly advantageous for a given application.

The holes may be arranged in a matrix.

The holes being arranged in a matrix may be understood to mean that the spacing between the holes is generally uniform. The spacing may be uniform in two directions.

Where the holes are arranged in a matrix, adhesion between the clip and the die and between the clip and the isolator in use is advantageously more uniform. This is as compared to if the holes were to have a non-uniform distribution. Uniform adhesion advantageously reduces the likelihood of delamination of the components of the semiconductor device.

The region or regions of the clip to which the plurality of holes are provided may have a porosity of up to 30%.

The clip may comprise a first portion for attachment to a die of the semi-conductor device. The clip may comprise a second portion for attachment to a lead portion of a lead frame of the semi-conductor device. The clip may comprise a transition portion that adjoins the first portion and the second portion. The plurality of holes may be provided to the first portion and the second portion.

The first portion and the second portion may be non-coplanar. The plurality of holes may be provided to the first portion and the second portion only. The plurality of holes may be provided to the entire clip. The second portion may be for direct attachment to a plurality of leads. The clip may comprise a plurality of leads. The plurality of leads may extend from the clip in a continuous manner. The plurality of leads may be integrally formed with the clip.

In a second aspect of the invention there is provided a semi-conductor device. The semi-conductor device comprises a lead frame; a semi-conductor die mounted on the lead frame; and a clip according to the first aspect of the invention. A part of the clip is secured to the semi-conductor die.

The advantages discussed above in relation to the first aspect of the invention apply mutatis mutandis to the second aspect of the invention.

The clip may define a first portion that is attached to the semi-conductor die. The plurality of holes may be provided to the first portion of the clip.

The plurality of holes may be provided to only the first portion of the clip.

The first portion may comprise at least one dimple. At least some of the plurality of holes may be provided in the region of the at least one dimple.

The holes may be only be provided in the region of the dimple.

The clip is typically secured to the semi-conductor die using solder, but may be secured to the semi-conductor die using an adhesive. In the absence of the plurality of holes, the solder or adhesive that secures the clip to the semi-conductor die is thinnest in the region of the dimple. This creates a weak point in the bond between the clip and the semi-conductor die, which increases the likelihood of cracking of the solder. Where the plurality of holes are provided in the region of the at least one dimple, the amount of solder or adhesive provided is increased as compared to where no holes are provided in that region. Increasing the amount of solder or adhesive in the region of the at least one dimple advantageously reduces the likelihood of the solder cracking.

The lead frame may comprise a die attach portion and a lead portion. The die may be mounted on the die attach portion. A second portion of the clip may be secured to the lead portion of the lead frame.

The clip may comprise a plurality of leads. The plurality of leads may form a part of or extend from the second portion of the clip. The plurality of leads may extend through the cover. The plurality of leads may allow connection of the device to an external circuit. The plurality of leads may extend from the clip in a continuous manner. The plurality of leads may be integrally formed with the clip.

The semi-conductor device may further comprise a cover. At least part of the cover may extend into at least one hole of the plurality of holes.

Where the cover extends into at least one hole of the plurality of holes, adhesion between the clip and the cover is advantageously improved. This is because the contact area between the cover and the clip is increased. This is desirable because improving adhesion between the clip and the cover reduces the likelihood of separation of the cover from the clip.

The semi-conductor device may further comprise a solder layer that secures the clip to the semi-conductor die. At least part of the solder layer may extend into at least one hole of the plurality of holes.

Where the solder layer extends into at least one hole of the plurality of holes, adhesion between the solder layer and the cover is advantageously improved. This is because the contact area between the solder layer and the clip is increased. This is desirable because improving adhesion between the clip and the solder layer reduces the likelihood of separation of the clip from the solder layer.

### Brief Description of the Drawings

Embodiments of the present invention will now be described with reference to the accompanying drawings, in which:
Figure 1 shows a perspective view of a semi-conductor device;
Figure 2 shows a perspective view of a clip of the semi-conductor device of Figure 1;
Figure 3 shows a cross-sectional view of the semi-conductor device of Figure 1;
Figure 4 shows a cross-sectional view of the semi-conductor device of Figure 1;
Figure 5 shows an alternative embodiment of the clip of Figure 2; and
Figures 6a to 6d show alternative embodiments of the clip of Figure 2.

### Detailed Description

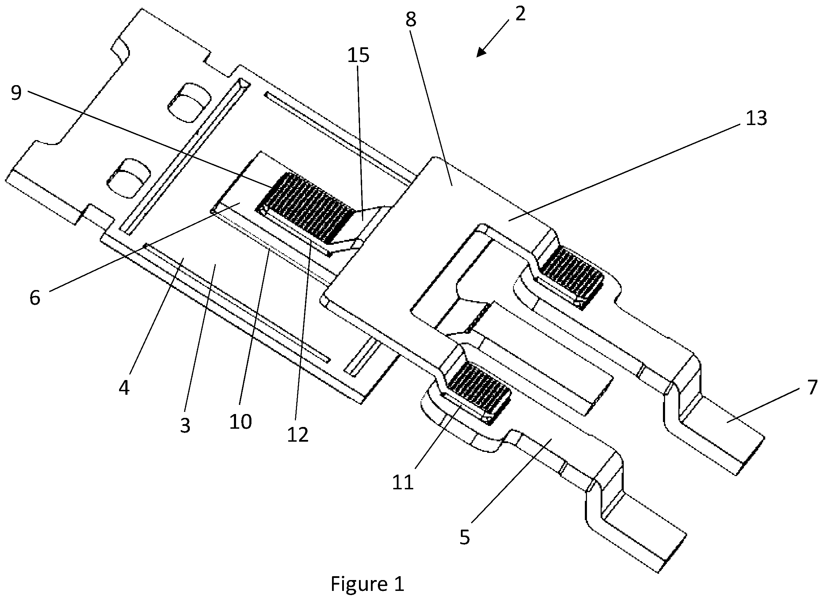

Figure 1 shows a semiconductor device 2. The semi-conductor device 2 comprises a lead frame 4. The lead frame 4 may also be referred to as a die paddle. The semiconductor device 2 comprises a die 6. The semi-conductor device 2 comprises a clip 8.

The lead frame 4 serves as a base of the semi-conductor device 2 to which other components of the device are attached. The lead frame 4 comprises a die attach portion 3. The die 6 is secured to the die attach portion 3. The lead frame 4 comprises a lead portion 5. In the depicted embodiment, the lead portion 5 comprises two separately formed portions. However, in some, non-depicted, embodiments, the lead portion 5 may comprise only a single portion. The lead portion 5 comprises a plurality of leads 7 (only one of which is labelled in Figure 1). Each lead of the plurality of leads extends from a respective portion of the lead portion 5. The plurality of leads 7 allow the semiconductor device 2 to be connected to an external circuit (not shown). The lead frame 4 is manufactured from a conductive material such as copper (including a copper alloy). The lead portion 5 is separately formed from the die attach portion 3. However, in some embodiments, the lead portion 5 and the die attach portion 3 may be integrally formed.

The die 6 is secured to the lead frame 4. The die 6 is secured to the lead frame 4 by virtue of a first solder layer 10. In particular, the die 6 is secured to the die attach portion 3 of the lead frame 4 by the first solder layer 10. The die 6 may be a single component or may comprise multiple constituent components. The die 6 is made of a semi-conducting material. The die 6 has a functional circuit fabricated thereon. The die 6 is generally rectangular but may be any other suitable shape. The die 6 is plate like in shape.

The clip 8 comprises a first portion 9, a second portion 13, and a transition portion 15. The transition portion 15 adjoins and is disposed between the first portion 9 and the second portion 13. The first portion 9 and the second portion 13 are non-coplanar. The clip 8 is secured to the die 6. The clip 8 is secured to the die 6 by virtue of a second solder layer 12. In particular, the first portion 9 of the clip 8 is secured to the die 6 by virtue of the second solder layer 12. The clip 8 is secured to the lead portion 5 of the lead frame 4. The clip 8 is secured to the lead portion 5 of the lead frame 4 by virtue of a third solder layer 11. In particular, the second portion 13 of the clip 8 is secured to the lead portion 5 of the lead frame 4 by virtue of the third solder layer 11. The clip 8 thus electrically connects the die 6 and the lead portion 5 of the lead frame 4. The clip 8 may otherwise be referred to as a connector. In some embodiments, the lead portion 5 may extend continuously from the clip 8. Where the lead portion 5 extends continuously from the clip 8, the lead portion 5 may be integrally formed with the clip 8. That is to say, the lead portion 5 and leads 7 may form a part of the clip 8.

The semi-conductor device 2 further comprises a cover (not shown in Figure 1 for clarity). The cover may also be referred to as an isolator, a casing, or an encapsulant. The cover encapsulates the remaining components of the semi-conductor device 2 (i.e., the lead frame 4, the die 6, and the clip 8). The leads 7 of the clip 8 extend through the cover. This allows the leads 7 to be connected to the external circuit (not shown). The cover may be made from any suitable electrically isolating material, such as an epoxy.

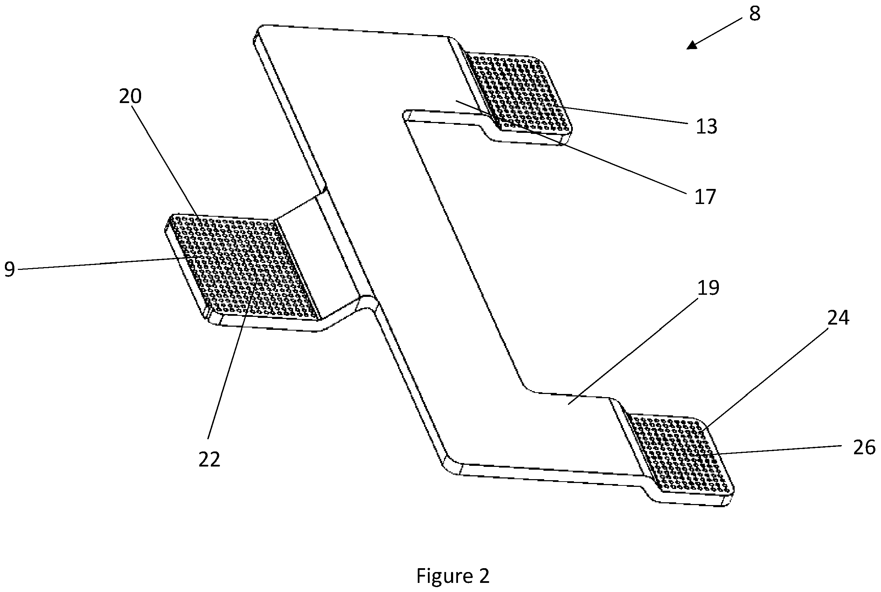

Figure 2 shows a perspective view of the clip 8. The first portion 9 of the clip 8 comprises a first major surface 20. The first portion 9 of the clip 8 comprises a second major surface (not visible in Figure 2 it is hidden by the clip 8). The second major surface is generally opposed to the first major surface 20. The first portion 9 of the clip 8 defines a first plurality of holes 22 (only one of which is labelled in Figure 2). The first plurality of holes 22 extend through the first portion 9 of the clip 8. The first plurality of holes 22 extend from the first major surface 20 of the first portion 9 of the clip 8 to the second major surface of the first portion 9 of the clip 8. The first plurality of holes 22 may be referred to as through holes. The first plurality of holes 22 define a hole density. The hole density may be understood to refer to the number of holes present per unit area. The relevant area being an area of the first major surface 20 and of the region or regions of the first portion 9 to which the holes 22 are provided (the area including the area occupied by the holes). The hole density is at least 4 holes/mm². This hole density advantageously improves adhesion between the clip 8 and the die 6, and between the clip 8 and the cover, as will be discussed in more detail below. In some embodiments, the hole density may be at least 25 holes/mm². In some embodiments, the hole density may be up to 50 holes/mm² or 100 holes/mm². The hole density may be chosen based on, for example, the intended application of the semi-conductor device. The first plurality of holes 22 may result in the porosity of the region or regions of the first portion 9 being up to 30%. Porosity is a function of the hole density, and the size of the holes of the first plurality of holes 22. The porosity of the first portion 9 of the clip 8 may be chosen based on the desired flexibility of the first portion 9 of the clip 8, and of the clip 8 as a whole.

The second portion 13 of the clip 8 comprises a first arm 17 and a second arm 19. However, in some embodiments, the second portion 13 may comprise only a single arm. The second portion 13 of the clip 8 comprises a first major surface 24. The second portion 13 of the clip 8 comprises a second major surface (not visible in Figure 2 it is hidden by the clip 8). The second major surface is generally opposed to the first major surface 24. The first major surface 24 and the second major surface each comprise a portion that forms a part of the first arm 17 and a portion that forms a part of the second arm 19.

The second portion 13 of the clip 8 defines a second plurality of holes 26 (only one of which is labelled in Figure 2). The second plurality of holes 26 extend through the second portion 13 of the clip 8. The second plurality of holes 26 extend from the first major surface 24 of the second portion 13 of the clip 8 to the second major surface of the second portion 13 of the clip 8. The second plurality of holes 26 extend through a distal portion of the first arm 17 and of the second arm 19. The second plurality of holes 26 may be referred to as through holes. The second plurality of holes 26 define a hole density. The hole density of the second plurality of holes 26 may be equal to the hole density of the first plurality of holes 22. The hole density may be understood to refer to the number of holes present per unit area. The relevant area being an area of the region or regions of the second portion 13 to which the holes 26 are provided (the area including the area occupied by the holes).. The hole density is at least 4 holes/mm². This hole density advantageously improves adhesion between the clip 8 and the die 6, and between the clip 8 and the cover. In some embodiments, the hole density may be at least 25 holes/mm². In some embodiments, the hole density may be up to 50 holes/mm² or 100 holes/mm². The hole density may be chosen based on, for example, the intended application of the semi-conductor device. The second plurality of holes 26 may result in the porosity of the region or regions of the second portion 13 to which they are provided being at least 30%. Porosity is a function of the hole density, and the size of the holes of the second plurality of holes 26. The porosity of the second portion 13 of the clip 8 may be chosen based on the desired flexibility of the second portion 13 of the clip 8, and of the clip 8 as a whole. In some embodiments, all regions of the clip 8 may be provided with holes.

The holes 22, 26 are arranged in a matrix. The holes 22, 26 being arranged in a matrix may be understood to mean that the spacing between the holes, in particular the spacing between centre points of the holes, is generally uniform. In some, non-depicted, embodiments the arrangement of the holes of the plurality of holes need not be uniform, and so may be arranged in any particular pattern. Each of the holes 22, 26 is generally circular in cross section. However, in other embodiments, the cross sectional shape of the holes may take any other suitable shape, some of which will be discussed in more detail below. The holes 22, 26 may be formed by a laser or by stamping.

A length of each hole of the plurality of holes may be at least 50µm and up to 500µm. The length of the hole refers to the largest dimension of the respective hole in a direction perpendicular to a central axis of the respective hole (or in a direction parallel to a plane defined by the first major surface 20, 24 of the relevant one of the first portion 9 and the second portion 13). The length of the holes 22, 26 may be chosen based on the desired flexibility of the clip 8 - larger holes will make the clip 8 more flexible and small holes will make the clip 8 less flexible.

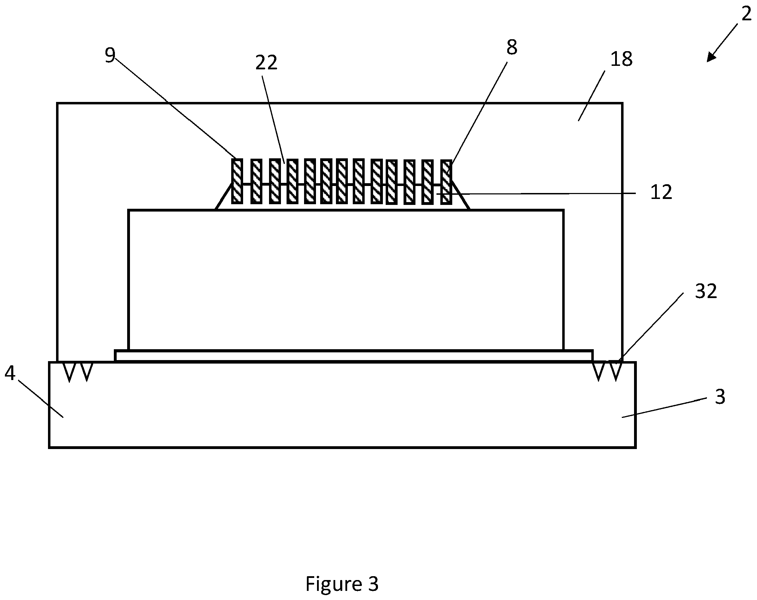

Figure 3 shows a cross-sectional view of the semi-conductor device 2. The cross-sectional view of Figure 3 is taken through the first portion 9 of the clip 8. As can be seen from Figure 3, at least part of the second solder layer 12 extends into the holes of the first plurality of holes 22. This advantageously improves the adhesion between the second solder layer 12 and the clip 8. This is because the contact area between the second solder layer 12 and the clip 8 is increased. The adhesion is further improved because the bond line thickness and volume of the second solder layer 12 is increased as compared to if the holes were not provided. Improving the adhesion between the clip 8 and the first solder layer 12 advantageously reduces the likelihood of separation of the clip 8 from the second solder layer 12. Similarly, at least part of the cover 18 extends into the holes of the first plurality of holes 22. This improves the adhesion between the clip 8 and the cover 18. Improving the adhesion between the cover 18 and the clip 8 is desirable because this reduces the likelihood of separation of the cover from the clip 8. The adhesion between the cover 18 and the clip 8 is improved because the contact area between the cover 8 and the clip 18 is increased, and because the volume of the cover 18 is increased.

The die attach portion 3 of the lead frame 4 is provided with a plurality of grooves 32. The plurality of grooves 32 are provided in the region of the die attach portion 3 that is in (direct) contact with the cover 18. Therefore, at least part of the cover 18 extends into the grooves 32. The cover 18 extending into the grooves 32 advantageously increases the contact area between the cover 18 and the die attach portion 3 of the lead frame 4. Increasing the contact area between the cover 18 and the die attach portion 4 of the lead frame 4 advantageously increases the adhesion between the cover 18 and the die attach portion 3, which reduces the likelihood of separation of the cover from the die attach portion 3. In some embodiments, the grooves 32 need not be provided.

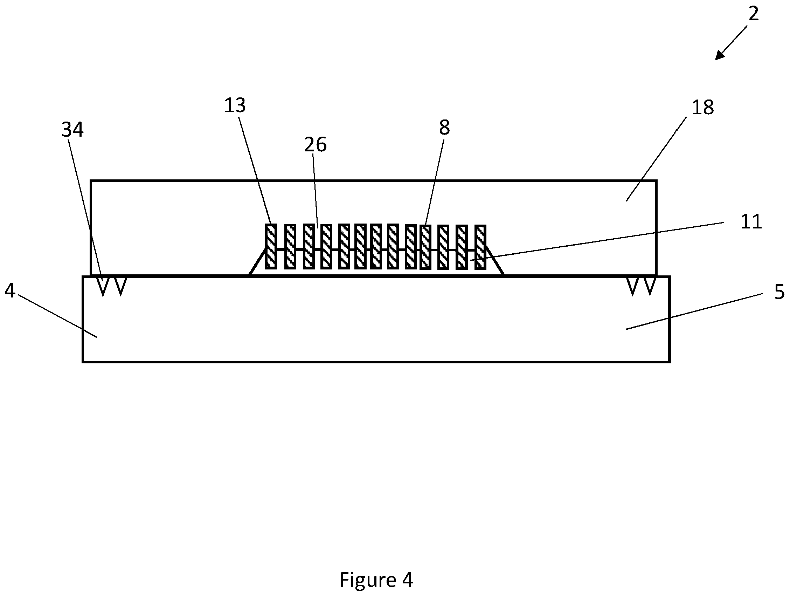

Figure 4 shows a cross-sectional view of the semi-conductor device 2. The cross-sectional view of Figure 4 is taken through the second portion 13 of the clip 8. As can be seen from Figure 4, at least part of the third solder layer 11 extends into the holes of the second plurality of holes 26. This advantageously improves the adhesion between the third solder layer 11 and the clip 8. This is because the contact area between the third solder layer 11 and the clip 8 is increased. The adhesion is further improved because the bond line thickness and volume of the third solder layer 11 is increased as compared to if the holes were not provided. Improving the adhesion between the clip 8 and the third solder layer 11 advantageously reduces the likelihood of separation of the clip 8 from the third solder layer 11. Similarly, at least part of the cover 18 extends into the holes of the second plurality of holes 26. This improves the adhesion between the clip 8 and the cover 18. Improving the adhesion between the cover 18 and the clip 8 is desirable because this reduces the likelihood of separation of the cover from the clip 8. The adhesion between the cover 18 and the clip 8 is improved because the contact area between the cover 8 and the clip 18 is increased and because the volume of the cover 18 is increased.

The lead portion 5 of the lead frame 4 is provided with a plurality of grooves 34. The plurality of grooves 34 are provided in the region of the lead portion 5 that is in (direct) contact with the cover 18. Therefore, at least part of the cover 18 extends into the grooves 34. The cover 18 extending into the grooves 34 advantageously increases the contact area between the cover 18 and the lead portion 5 of the lead frame 4. Increasing the contact area between the cover 18 and the grooves 34 advantageously increases the adhesion between the cover 18 and the lead portion 5 of the lead frame 4, which reduces the likelihood of separation of the cover from the lead portion 5. In some embodiments, the grooves 34 need not be provided.

In use, the semi-conductor device 2 is subject to fluctuations in temperature. The fluctuations in temperature result in the expansion and contraction in the size of the components of the semi-conductor device. Each component of the semi-conductor device 2 has a different co-efficient of thermal expansion. This is by virtue of each component of the semi-conductor device being made from a different material. Since the components of the semi-conductor device are secured to one another and since each is expanding or contracting by a different amount during use, internal stresses arise as a result of the temperature fluctuations. These internal stresses can result in failure of the semi-conductor device by, for example, delamination of the components of the device. The first and second plurality of holes 22, 26 reduce the likelihood of delamination of the components. This is because the holes 22, 26 increase the flexibility of the clip 8, as compared to where no holes are provided. Increasing the flexibility of the clip 8 allows the clip 8 to better withstand the internal stresses, which reduces the likelihood of delamination of the components of the clip 8. The holes also reduce the spread of the solder layers that may occur as a result of heating of carried out during manufacture of the semi-conductor device 2.

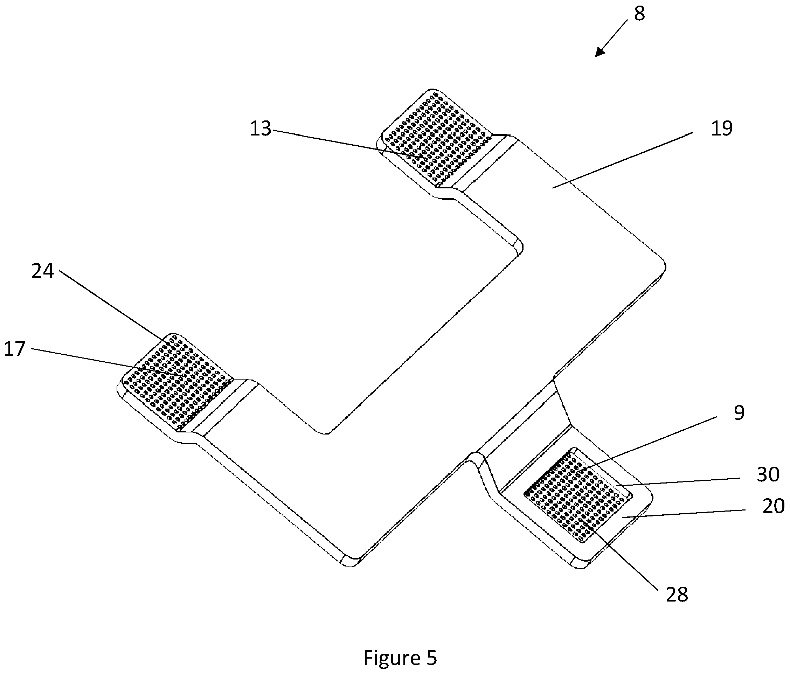

The clip 8 of Figure 5 is similar to the clip of Figure 1 but differs in that the first portion 9 of the clip 8 of Figure 5 comprises a dimple 28. In the depicted embodiment, the first portion 9 comprises the only one dimple 28. However, in some embodiments, the clip 8 may comprise a plurality of dimples. The first portion 9 may comprise a plurality of dimples. Where the clip 8 comprises a plurality of dimples, each of the first portion 9 and the second portion 13 may comprise one or a plurality of dimples. Where the second portion 13 is provided with a dimple, one or both of the first arm 17 and the second arm 19 may comprise a single dimple or a plurality of dimples. The dimple 28 is formed by stamping a depression 30 into the first major surface 20, 24 of the first portion 9 (or of the second portion 13 of the clip 8). Stamping of the clip 8 to form the depression 30 results in a protrusion (not visible in Figure 5 - it is hidden by the clip 8 itself) that extends from the second major surface of the first portion 9. The protrusion is disposed at a location corresponding to a respective depression 30. In the depicted embodiment, the plurality of holes 22 are provided in the region of the dimple 28. In some embodiments, the plurality of holes 22 may be provided outside of the region of the dimple 28. The dimple 28 and depression 30 is provided to better secure the clip 8 to the die and to the lead portion of the lead frame.

During assembly, the surface tension of the solder draws the clip 8 towards the die 6 or lead portion 5 of the lead frame 4. Providing one or more holes in the region of the dimple 28 advantageously increases the bond line thickness and volume of the solder. This strengthens the adhesion between the clip 8 and the die 6. This reduces the likelihood of separation of the components of the device 2.

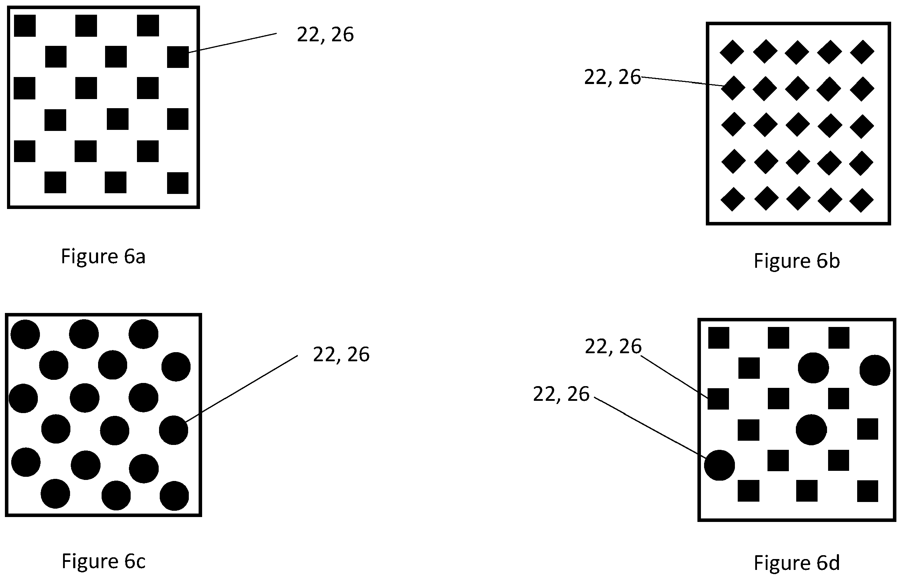

Figures 6a-6d show some alternative hole shapes. The alternative hole shapes shown apply to both the first plurality of holes 22 of the first portion 9 of the clip 8, and to the second plurality of holes 26 of the second portion 13 of the clip 8. In Figure 6a, the holes 22, 26 are square in cross-section. In some embodiments, the holes may be any quadrilateral shape in cross-section. In Figure 6b, the holes 22, 26 are diamond-shape in cross-section. In Figure 6c, the holes 22, 26 are circular in cross-section. In Figure 6d, the holes 22, 26 comprise holes that are circular in cross-section and holes that are square in cross-section. In some embodiments, the holes 22, 26 may comprise a mixture of holes of the different cross-sectional shapes disclosed herein.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A clip for a semi-conductor device, the clip being provided with a plurality of holes, wherein the plurality of holes define a hole density of at least 4 holes/mm².

2. The clip of claim 1, wherein a length of each hole of the plurality of holes is at least 50µm and up to 500µm.

3. The clip of claim 1 or claim 2, wherein the holes are circular, triangular, and/or rectangular in cross-section.

4. The clip of any preceding claim, wherein the holes are arranged in a matrix.

5. The clip of any preceding claim, wherein the region or regions of the clip to which the plurality of holes are provided has a porosity of up to 30%.

6. The clip of any preceding claim, wherein the clip comprises a first portion for attachment to a die of the semi-conductor device, a second portion for attachment to a lead portion of a lead frame of the semi-conductor device, and a transition portion that adjoins the first portion and the second portion, wherein the plurality of holes are provided to the first portion and the second portion.

7. A semi-conductor device comprising:
a lead frame;
a semi-conductor die mounted on the lead frame;
a clip according to any preceding claim, a part of the clip being secured to the semi-conductor die.

8. The clip of claim 7, wherein the clip defines a first portion that is attached to the semi-conductor die, and wherein the plurality of holes are provided to the first portion of the clip.

9. The semi-conductor device of claim 8, wherein the first portion comprises at least one dimple, and wherein at least some of the plurality of holes are provided in the region of the at least one dimple.

10. The semi-conductor device of any of claims 7 to 9, wherein:
the lead frame comprises a die attach portion and a lead portion,
the die is mounted on the die attach portion, and
a second portion of the clip is secured to the lead portion of the lead frame.

11. The semi-conductor device of any of claims 7 to 10, further comprising a cover, wherein at least part of the cover extends into at least one hole of the plurality of holes.

12. The semi-conductor device of any of claims 7 to 11, further comprising a solder layer that secures the clip to the semi-conductor die, and wherein at least part of the solder layer extends into at least one hole of the plurality of holes.
